Europäisches Patentamt

European Patent Office

Office européen des brevets

(19)

(11) Veröffentlichungsnummer: **0 003 130**
B1

(12) **EUROPÄISCHE PATENTSCHRIFT**

(21) Anmeldenummer: **79100063.1**

(22) Anmeldetag: **10.01.79**

(51) Int. Cl.³: **H 01 L 29/91,**
**H 01 L 31/06, H 03 D 7/02,**
**H 03 B 19/00, H 03 K 17/04**

(54) Halbleiter-Diode mit 3-Schichten-Struktur und ihre Verwendung.

(30) Priorität: **10.01.78 DE 2800820**

(43) Veröffentlichungstag der Anmeldung:
**25.07.79 Patentblatt 79/15**

(45) Bekanntmachung des Hinweises auf die Patenterteilung:
**11.02.81 Patentblatt 81/6**

(84) Benannte Vertragsstaaten:
**BE CH DE FR GB IT NL SE**

(56) Entgegenhaltungen:
**FR - A - 2 284 987**
**FR- -A - 2 288 398**

(73) Patentinhaber: **Mader, Hermann, Dr.**
**Carl-Duisberg-Strasse 42**
**D-8025 Unterhaching (DE)**

(72) Erfinder: **Mader, Hermann, Dr.**
**Carl-Duisberg-Strasse 42**
**D-8025 Unterhaching (DE)**

(74) Vertreter: **Mehl, Ernst, Dipl.-Ing.**
**Postfach 22 01 76**
**D-8000 München 22 (DE)**

Courier Press, Leamington Spa, England.

EP 0 003 130 B1

**0 003 130**

### Halbleiter-Diode mit 3-Schichten-Struktur und ihre Verwendung

Die Erfindung betrifft eine Halbleiter-Diode, wie sie im Oberbegriff des Patentanspruches 1 angegeben ist.

Es ist bekannt, daß sowohl bei pn- als auch bei Schottky-Dioden die Schwellenspannung im wesentlichen durch den Bandabstand des verwendeten Halbleiters bestimmt wird. Für Kleine Schwellenspannungen sind i.a. Halbleiter mit geringem Bandabstand erforderlich. Die Herstellung schmalbandiger Halbleiter-Dioden ist zur Zeit allerdings noch sehr schwierig und aufwendig.

Ferner ist bekannt, daß bei pn-Dioden Minoritätsträgerund bei Schottky-Dioden Majoritätsträgereffekte dominieren. Dementsprechend haben Schottky-Dioden wesentlich höhere Grenzfrequenzen als pn-Dioden.

Aus "Solid State Electronics" (1976) Bd.19, Seiten 625—631 ist eine sogenannte Baritt-pn-Diode bekannt, die als Generator zur Erzeugung sehr hoher Frequenzen, z.B. 10 GHz, verwendet wird. In dieser Diode werden Laufzeiteffekte ausgenutzt, die im wesentlichen in der mittleren Zwischenschicht der Diode auftreten. Diese Zwischenschicht weist, wie die Fig. 1 genannten Druckschrift zeigt, einen Aufbau und eine Dotierung auf, bei der ohne angelegte äußere Spannung, abgesehen von den äußersten Randbereichen, praktisch keine Verarmung an freien Ladungsträgern vorliegt. Die zur Ausnutzung der Laufzeiteffekte erforderlichen hohen Feldstärken in dieser Zwischenschicht begingen, daß diese Zwischenschicht eine erhebliche Mindestdotierung aufweist. Die wiederum durch die vorgegebene zu erzeugende Frequenz bedingte Dicke dieser Zwischenschicht führt dazu, daß nur die bereits erwähnten Randbereiche an freien Ladungsträgern verarmt sind.

Ebenfalls zur Erzeugung von Hochfrequenz dient eine aus der DE—OS 22 24 159 bekannte Lawinenlaufzeit-Diode, die aus zwei auf einer Metallelektrode übereinanderliegenden p- und n-Halbleiterschichten aufgebaut ist. Die bei diesem Heteroaufbau mittlere Schicht soll eine vergleichsweise zur darüberliegenden Halbleiterschicht eine um ca. zwei Größenordnungen höhere Dotierung aufweisen, so daß bei fehlender Betriebsspannung auch bei einer solchen Diode praktisch nur Randbereiche dieser mittleren Schicht eine Verarmung an freien Ladungsträgern aufweisen wie dies im übrigen von jeglichem pn-Ubergang bekannt ist.

Es ist eine Aufgabe der vorliegenden Erfindung, eine solche Halbleiter-Diode zu schaffen, die eine jeweils (technologisch) fest vorgebbare Höhe ihrer Energiebarriere hat, die unterhalb des durch den üblichen pn-Ubergang vorgegebenen Wert liegt. Insbesondere ist es eine Aufgabe der vorliegenden Erfindung, ein—nämlich aufgrund der verringerten Höhe der Energiebarriere—in seiner Empfindlichkeit verbessertes Fotoelement zu schaffen.

Diese Aufgabe wird mit einer Halbleiter-Diode nach dem Oberbegriff des Patentanspruches 1 erfindungsgemäß gelöst, wie dies im Kennzeichen des Patentanspruches 1 angegeben ist. Weitere Ausgestaltungen und auf der Erfindung beruhende weitere vorteilhafte Anwendungen der Erfindung gehen aus den Unteransprüchen hervor.

Der Erfundung liegt der Gedanke zugrunde, eine 3-Schichtstruktur aufzubauen, die entweder aus einer npn-Schicht- oder einer pnp-Schichtfolge besteht, bei der jedoch im Gegensatz zum Injektions-transistor die mittlere Schicht so dünn ist, daß bei wahlweise vorgegebener Dotierungshöhe dieser mittleren Schicht der gesamte Bereich dieser mittleren Schicht bereits ohne äußere angelegte elektrische Spannung von freien Ladungsträgern verarmt ist.

Für die Herstellung solcher Dioden eignen sich folgende an sich bekannte Verfahren:
a) Ionenimplantation,
b) Molekularstrahlepitaxie.

Die mit der Erfindung erzielten Vorteile bestehen insbesondere darin, daß die Schwellenspannung der Diode über technologische Parameter wie Dotierungsdichte oder Schichtdicke kontinuierlich im Bereich zwischen der thermischen Spannung $U_T$ und der Diffusionsspannung $U_D$ eingestellt werden kann. Bei Zimmertemperatur betragen $U_T \simeq 25$ mV und $U_D \simeq 1$ V. Es ist daher z.B. möglich, Silizium-Dioden mit sehr kleinen Schwellenspannungen zu realisieren.

Ein weiterer Vorteil beseht darin, daß wegen des dominierenden Majoritätsträgerstromes die Diode bis zu sehr hohen Frequenzen eingesetzt werden kann.

Die Erfindung wird nun anhand der in der Zeichnung dargestellten Figuren näher erläutert und beschrieben. Es zeigen
Fig. 1 schematisch den Aufbau der Halbleiter-Diode nach der Erfindung,
Fig. 2 den Verlauf der Raumladungsdichte in der Diode bei thermischen Gleichgewicht,
Fig. 3 den Verlauf der elektrischen Feldstärke bei thermischem Gleichgewicht,
Fig. 4 den Verlauf des elektrischen Potentials bei thermischem Gleichgewicht,
Fig. 5 den Verlauf des elektrischen Potentials bei angelegter positiver Spannung,
Fig. 6 den Verlauf des elektrischen Potentials bei angelegter negativer Spannung,
Fig. 7 Potentialbarriere $\varphi_R$ und $\varphi_L$ in Abhängigkeit der angelegten Spannung,
Fig. 8 den prinzipiellen Verlauf der Strom-Spannungskennlinie,
Fig. 9 Strom-Spannungskennlinien für zwei Dioden mit unterschiedlicher Basisdicke,
Fig. 10 eine andere Ausführungsform einer erfindungsgemäßen Diode mit einem Aufbau nach Art einer Mesastruktur, wobei diese Diode auch in ihrer Verwendung als foto-voltaischer Detektor gezeigt

2

ist,

Fig. 11 bis 13 Prinzipschaltbilder zu Verwendungen einer erfindungsgemäßen Diode als Klammer-Diode (Fig. 11), als Frequenzwandler (Fig. 12) und als Mischer (Fig. 13).

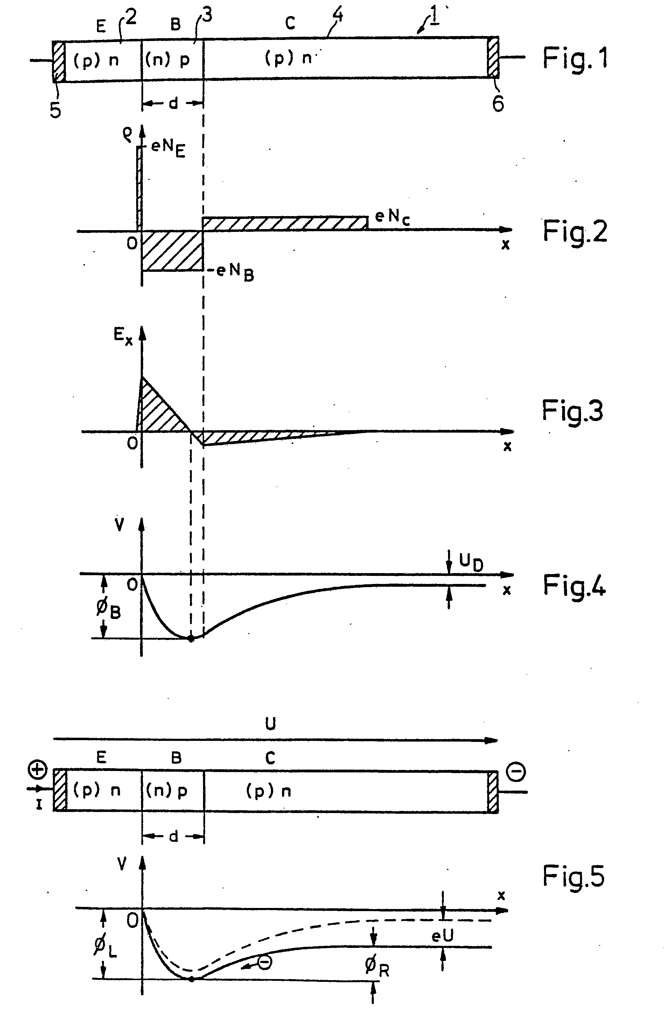

In Fig. 1 ist der Aufbau der Halbleiter-Diode 1 schematisch dargestellt. Die Diode 1 besteht wie ein an sich bekannter Injektionstransistor aus einer npn- oder einer pnp-3-Schichtstruktur mit den drei aneinandergrenzenden Schichten 2, 3 und 4. Die Elektroden sind mit 5 und 6 bezeichnet und bilden ohmsche Kontakte. Im Gegensatz zum bekannten Injektionstransistor ist bei der Erfindung die Basiszone (B), d.h. die Schicht 3, jedoch so kurz bzw. so dünn, daß bereits ohne äußere angelegte Spannung ihr gesamter Bereich von freien Ladungsträgern verarmt ist. Das sich dabei ergebende zahlenmäßige Maß der Dicke d ist abhängig von der gewählten Dotierungsdichte.

Fig. 2 zeigt den örtlichen Verlauf der Raumladungsdichtes in der Diode 1 bei thermischem Gleichgewicht, d.h. ohne äußere angelegte Spannung. Die Basis (B) bzw. Schicht 3 enthält im Gegensatz zum bekannten Injektionstransistor bei der Erfindung keinen neutralen Bereich. Die Raumladungsdichten in den einzelnen Zonen werden durch die entsprechenden Dotierungsdichten bestimmt. In Fig. 2 sind $N_E$, $N_B$ und $N_C$ die Dotierungsdichten in Emitter (E), Basis (B) und Kollektor (C) und $e = 1,6.10^{-19}$ As, die Elementarladung.

In Fig. 3 ist der örtliche Verlauf der elektrischen Feldstärke $E_x$ in der Diode wiederum für thermisches Gleichgewicht dargestellt, der aus der Raumladungsdichte $eN(x)$ durch folgende Integration hervorgeht:

$$E_X = \int_{x_1}^{x_2} \frac{eN(x)}{\epsilon} \, dx \qquad (1)$$

In Gleichung (1) ist $\epsilon$ die Dielektrizitätskonstante des verwendeten Halbleiters.

Fig. 4 stellt den räumlichen Verlauf des elektrischen Potentials $V(x)$ in der Diode 1 bei thermischem Gleichgewicht dar. Die Höhe des Potentialberges $\varphi_B$ hängt von der Dicke d und der Dotierungsdichte $N_B$ der Basis wie folgt ab:

$$\phi_B \simeq \frac{eN_B}{2\,\epsilon} \cdot d^2 \qquad (2)$$

Gleichung (2) gilt für $N_E \gg N_B \gg N_C$.

Aus Gleichung (2) geht hervor, daß die Potentialberghöhe $\varphi_B$ durch d und $N_B$ technologisch eingestellt werden kann.

Für die Diffusionsspannung $U_D$ gilt:

$$U_D = U_T \cdot 1n(N_E/N_C) \qquad (3)$$

Die Diffusionsspannung $U_D$ wird durch die thermische Spannung $U_T$ ($U_T \simeq 25$ mV bei Zimmertemperatur) und das Verhältnis von Emitter- zu Basisdotierungsdichte $N_E/N_C$ bestimmt.

Fig. 5 zeigt den räumlichen Verlauf des elektrischen Potentials in der Diode bei angelegter positiver Spannung. Die Raumladungszonen werden dabei so verschoben, daß die rechte Potentialbarriere $\varphi_R$ kleiner wird als die linke, $\varphi_L$. Es gelangen somit mehr Majoritätsträger vom Kollektor (C) zum Emitter (E) als umgekehrt. Der resultierende elektrische Strom I läßt sich berechnen aus:

$$I \simeq I_s \cdot \exp(-\varphi_R/U_T) \qquad (4)$$

In Gl. (4) ist $I_s$ der Sättigungsstrom. Der Strom I steigt mit kleiner werdender Potentialbarriere $\varphi_R$.

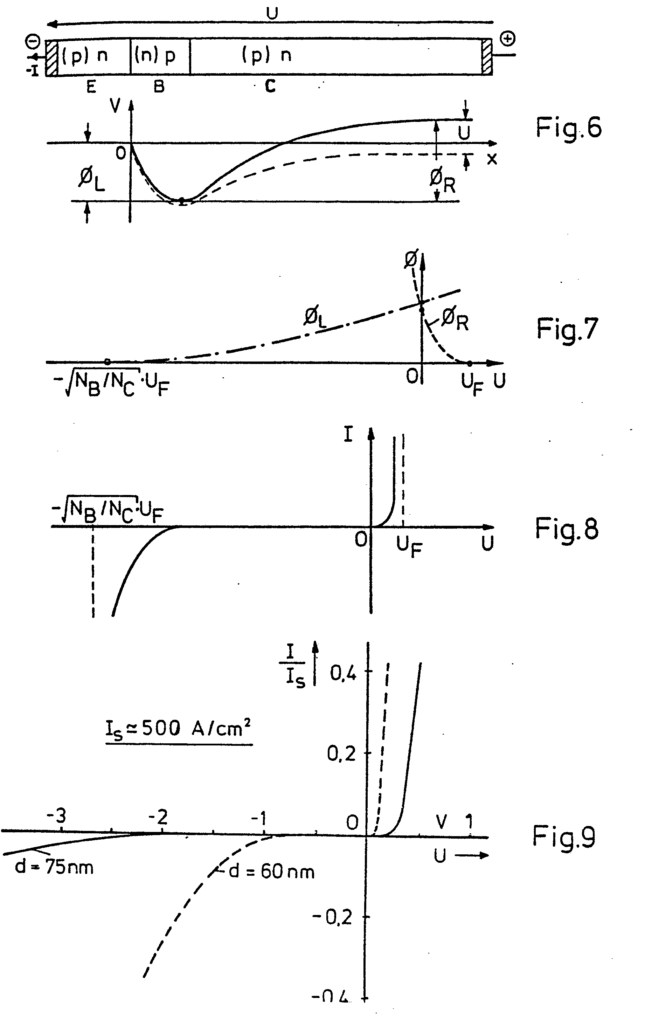

In Fig. 6 ist der räumliche Verlauf des elektrischen Potentials in der Diode bei angelegter negativer Spannung dargestellt. In diesem Fall ergibt die Verschiebung der Raumladungszonen eine kleinere linke Potentialbarriere $\varphi_L$. Für den elektrischen Strom I erhält man entsprechend:

$$I \simeq -I_s \exp(-\varphi_L/U_T) \qquad (5)$$

Fig. 7 zeigt die Spannungsabhängigkeit der Potentialbarrieren $\varphi_R$ und $\varphi_L$. Bei $U = O$ unterscheiden sich $\varphi_R$ und $\varphi_L$ lediglich um die kleine, durch Gl. (3) gegebene Diffusionsspannung $U_D$. Mit steigender positiver Spannung sinkt $\varphi_R$. Bei der Flachbandspannung $U_F$ ist die rechte Potentialbarriere $\varphi_R$ ganz abgebaut. Für $N_E \gg N_B \gg N_C$ gilt:

$$U_F = \frac{eN_B}{\epsilon} \cdot d^2 = 2\phi_B \qquad (6)$$

3

Die Flachbandspannung $U_F$ ist gleich der doppelten Potentialberghöhe $\varphi_B$ bei thermischem Gleichgewicht (siehe Fig. 4). Mit wachsender negativer Spannung wird $\varphi_L$ kleiner und errircht bei der Spannung $-\sqrt{N_B/N_C}\cdot U_F$ den Wert Null. Das Verhältnis von Basis- zu Kollektordotierungsdichte $N_B/N_C$ bestimmt somit die Unsymmetrie der Spannungsabhängigkeit von $\varphi_R$ und $\varphi_L$ und nach den Gln. (4) und (5) auch die Unsymmetrie der Strom-Spannungskennlinie.

In Fig. 8 ist der prinzipielle Verlauf der Strom-Spannungskennlinie dargestellt. Während bei positiven Spannungen der Strom I in der Nähe der Flachbandspannung $U_F$ stark ansteigt, geschieht dies im Sperrbereich der Diode erst bei Spannungen in der Gegend von $\sqrt{N_B/N_C}\cdot U_F$. Die Unsymmetrie der Kennlinie hängt also stark vom Verhältnis der Dotierungsdichten in Basis und Kollektor ab. Die Strom-Spannungskennlinie läßt sich bei $N_E \gg N_B \gg N_C$ ausdrücken durch:

$$
I \simeq
\begin{cases}
I_S \cdot \exp\left[-\dfrac{U_F}{2U_T}\left(1-\dfrac{U}{U_F}\right)^2\right]\left[1-\exp\left(-\dfrac{U}{U_T}\right)\right] & \text{für } U \geqq 0 \\[3ex]
-I_S \cdot \exp\left[-\dfrac{U_F}{2U_T}\left(1+\dfrac{U}{\sqrt{N_B/N_C}\cdot U_F}\right)^2\right]\left[1-\exp\left(\dfrac{U}{U_T}\right)\right] & \text{für } U < 0
\end{cases}
\tag{7}
$$

$I_s$ Sättigungsstrom
$U_F$ Flachbandspannung, nach Gl. (6) mit $N_B$ und d technologisch einstellbar
$U_T$ Thermische Spannung ($U_T \simeq 25$ mV bei Zimmertemperatur
$N_{B,C}$ Dotierungsdichten von Basis bzw. Kollektor.

Fig. 9 zeigt Strom-Spannungskennlinien für zwei Silizium-Dioden mit unterschiedlicher Basisdicke. Es wurden bei der Berechnung folgende Daten angenommen:
Emitterdotierung $N_E = 10^{19}$ cm$^{-3}$,
Basisdotierung $N_B = 10^{17}$ cm$^{-3}$,
Kollektordotierung $N_C = 10^{15}$ cm$^{-3}$.

Basisdicke $d_1 = 60$ nm für 1. Diode (---)
$d_2 = 75$ nm für 2. Diode (—)

Aus Fig. 9 geht hervor, daß bei beiden Dioden die Schwellenspannung kleiner als 0,5 V ist. Das Sperrverhalten richtet sich nach dem Verhältnis von $N_B/N_C$ (siehe Fig. 8). Bei größerem Unterschied der Dotierungsdichten $N_B$ und $N_C$ wird das Sperrverhalten der Dioden ausgeprägter.

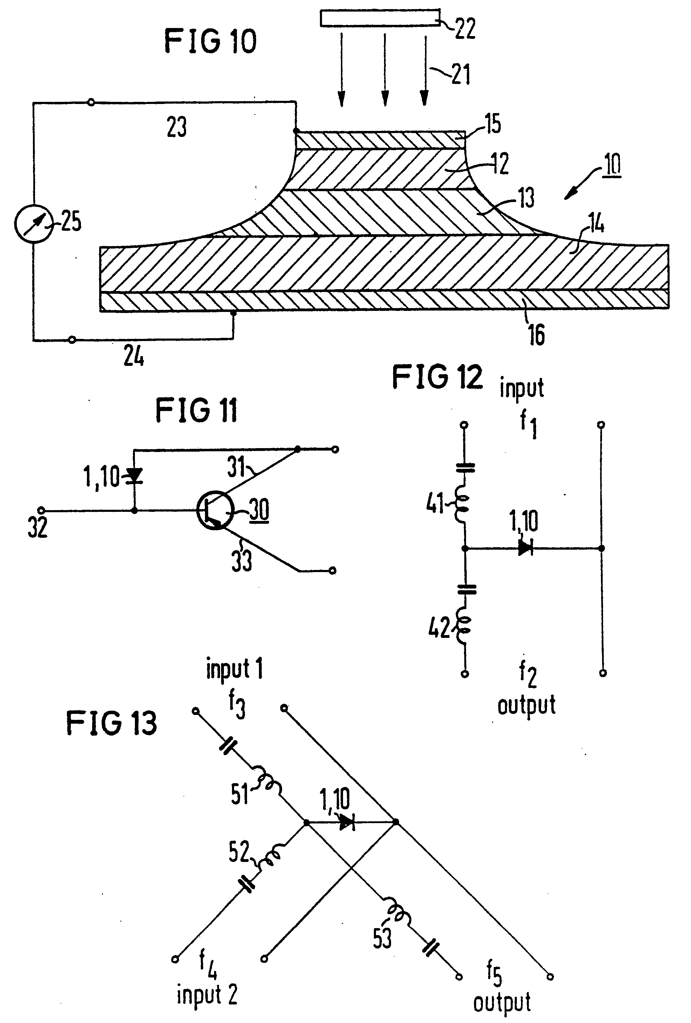

Fig. 10 zeigt eine andere spezielle Ausführungsform einer erfindungsgemäßen Diode 10, nämlich einer solchen, bei der die beiden pn-Übergangsflächen zwischen den Schichten 12 und 13 bzw. 13 und 14 verschiedene Größe haben. Diese Schichten 12, 13 und 14 entsprechen physikalisch den bereits oben ausführlich beschriebenen Schichten 2 und 3 und 4. Die ohmschen Kontakte sind mit 15 und 16 bezeichnet.

Aus der Fig. 10 geht des weiteren ein Beispiel für die Anwendung einer erfindungsgemäßen Diode als fotoempfindliches Bauelement, z.B. als foto-voltaischer Detektor, hervor. Diese Anwendung ist der Fig. 10 entsprechend für die Diode 10 beschrieben, gilt aber sinngemäß auch für eine Diode 1 nach der Fig. 1. Mit 21 ist eine elektromagnetische, insbesondere Lichtstrahlung, Ultraviolettstrahlung oder auch Infrarotstrahlung angedeutet, die z.B. von einer Lichtquelle 22 herrührt. Diese Strahlung 21 dringt durch die zu diesem Zweck durchlässig ausgeführte Elektrode 15 hindurch in die Schichten 12, 13 und 14 der Diode 10 ein. Statt einer Durchlässigkeit der Diode 15 kann die Elektrode 15 auch ringförmig oder perforiert ausgebildet sein. Die eingestrahlte Strahlung 21 erzeugt in der aus den Schichten 12, 13 und 14 aufgebaute Diode 10 eine foto-voltaische elektrische Spannung bzw. einen Fotostrom, der zwischen den mit den Elektroden 15 bzw. 16 verbundenen elektrischen Anschlüssen 23 und 24 abgenommen werden kann und z.B. durch das Meßinstrument 25 nachzuweisen ist.

Entsprechend der Quantenenergie der jeweils beispielsweise nachzuweisenden Strahlung 21 ist z.B. für Infrarotstrahlung eine besonders niedrige Höhe der Energiebarriere anzustreben, wie dies mit der Erfindung im Gegensatz zum Stand der Technik realisierbar ist. Speziell für ultraviolette Strahlung 21 empfiehlt es sich, die Schicht 12, bzw. die Schicht 2, dünn—z.B. dünner als 1 $\mu$m—auszubilden. Damit ist erreicht, daß die bei Ultraviolettstrahlung im wesentlichen bereits in den obersten Schichtanteilen der Schicht 12 erzeugten Ladungsträger optimal zum erzeugten Fotostrom bzw. zur erzeugten Fotospannung beitragen können.

Andere Anwendungen der Erfindung unter Ausnutzung der erfindungsgemäß herabsetzbaren Energiebarriere sind die Verwendung einer erfindungsgemäßen Diode als Klammerdiode (clamping Diode) in Verbindung mit Bipolartransistoren, nämlich zur Erhöhung deren Schaltgeschwindigkeit.

Fig. 11 zeigt ein Prinzipschaltbild einer solchen Anwendung mit einem Bipolartransistor 30, zwischen dessen Kollektorausgang 31 und Basiseingang 32 eine wie erfindungsgemäße Diode 1 bzw.

4

10 eingefügt ist. Mit 33 ist der Emitter des Transistors 30 bezeichnet.

Fig. 12 zeigt eine Prinzipschaltung der Verwendung einer erfindungsgemäßen Diode 1, 10 als Frequenzwandler-Diode, zur Umwandlung der Frequenz $f_1$ eines eingehenden Signals in irgendeine zur Frequenz $f_1$ harmonische Frequenz $f_2$ als ausgehendes Signal. Mit 41 und 42 sind Schwingkreise in dieser Prinzipschaltung bezeichnet.

Fig. 13 zeigt die Anwendung einer erfindungsgemäßen Diode 1, 10 in einer dem Prinzip nach dargestellten Mischerschaltung mit den Eingangsfrequenzen $f_3$ und $f_4$, aus denen das Ausgangssignal der Frequenz $f_5$ erzeugt wird. Mit 51, 52, 53 sind der Abstimmung dienende Schwingkreise bezeichnet.

Zum technologischen Aufbau einer erfindung gemäßen Diode ist noch anzumerken, daß für die einzelnen Schichten 2, 3, 4 bzw. 12, 13, 14 der Schichtstruktur ein und dasselbe Halbleitermaterial, z.B. ein Elementhalbleiter wie Silizium oder auch ein Verbindungshaltbleiter wie Galliumarsenid, verwendet werden kann. Vorteile können aber auch erreicht werden, wenn alle oder auch nur teilweise jeweils benachbarte Schichten aus zueinander jeweils verschiedenem Halbleitermaterial bestehen, wie z.B. die Schicht 2 oder 12 bzw. die Schicht 4 oder 14 aus Galliumarsenid und die benachbarte Schicht 3 oder 13 aus Gallium-Aluminiumarsenid.

Insbesondere im Zusammenhang mit Lumineszenz ist es vorteilhaft, ein Halbleitermaterial mit direktem Bandübergang, z.B. Galliumarsenid, für jeweils eine oder auch für alle Schichten 2 bis 4 bzw. 12 bis 14 einer erfindungsgemäßen Diode zu verwenden.

Für jeweils eine oder beide Elektroden einer erfindungsgemäß en Diode ist es für das Erreichen besserer ohmscher Kontakte und/oder zur Vermeidung eines Durchlegierens des Materials des Kontaktes bei den bei der Erfindung insbesondere dünnen Halbleiterschichten von Vorteil, ein Halbleiter-Metall-Verbundmaterial, wie z.B. Aluminium-Silizium-Material, zu verwenden. Ein solches Verbundmaterial wird z.B. durch gemeinsames, gleichzeitiges Aufdampfen von Silizium und Aluminium hergestellt.

*Erläuterung der verwendeten Symbole*

| | |
|---|---|
| $d$ | Dicke der Basiszone |
| $e$ | Elementarladung |
| $\varepsilon$ | Dielektrizitätskonstante des verwendeten Halbleiters |
| $E_x$ | elektrische Feldstärke |
| $I$ | elektrischer Strom |
| $I_s$ | Sättigungsstrom |
| $N_E$ | Dotierungsdichte des Emitters |
| $N_B$ | Dotierungsdichte der Basis |
| $N_C$ | Dotierungsdichte des Kollektors |
| $U$ | angelegte Spannung |
| $U_D$ | Diffusionsspannung |
| $U_F$ | Flachbandspannung |
| $V$ | elektrisches Potential |
| $\varphi$ | Potentialbarriere |
| $\varphi_B$ | Potentialbarriere bei thermischem Geichgewicht |
| $\varphi_{L,R}$ | Potentialbarrieren bei angelegter Spannung |
| $\varrho$ | Raumladungsdichte |

**Patentansprüche:**

1. Halbleiter-Diode mit einer npn- oder pnp-3-Schichtstruktur aus drei aneinandergrenzenden Halbleiterschichten und mit ohmschen Kontakten, gekennzeichnet dadurch, daß zur Verringerung der Energiebarriere die in der 3-Schichtstruktur mittlere Schicht (3, 13) (Basis B) in ihrer Dicke d so dünn gewählt ist, daß bereits ohne äußere an die Elektroden (5, 6, 15, 16) angelegte elektrische Spannung bei der gegebenen Dotierung dieser Schicht (3, 13) der gesamte Bereich dieser Schicht (3, 13) von freien Ladungsträgern verarmt ist (Fig. 1, Fig. 10).

2. Halbleiter-Diode nach Anspruch 1, dadurch gekennzeichnet, daß die Dotierungsdichten in allen Schichten der 3-Schichtstruktur gleich sind.

3. Halbleiter-Diode nach Anspruch 1, dadurch gekennzeichnet, daß die Dotierungsdichten in den Schichten der 3-Schichtstruktur ungleich sind.

4. Halbleiter-Diode nach Anspruch 1, 2 oder 3, dadurch gekennzeichnet, daß die Größe der Querschnitte bzw. der aufeinanderliegenden Grenzflächen der Schichten der 3-Schichtstruktur alle gleich sind.

5. Halbleiter-Diode nach Anspruch 1, 2 oder 3, dadurch gekennzeichnet, daß die jeweiligen pn-Übergangsflächen der drei Schichten der 3-Schichtstruktur verschieden groß sind (Fig. 10).

6. Halbleiter-Diode nach einem der Ansprüche 1 bis 5, gekennzeichnet dadurch, daß die Schichten (2, 3, 4, 12, 13, 14) der Schichtstruktur alle aus dem gleichen Halbleitermaterial bestehen.

7. Halbleiter-Diode nach einem der Anspruche 1 bis 5, gekennzeichnet dadurch daß die Schichten (2, 3, 4, 12, 13, 14) der Schichtstruktur aus mindestens zwei voneinander verschiedenen Halbleitermaterialien bestehen.

8. Halbleiter-Diode nach Anspruch 6 oder 7, gekennzeichnet dadurch, daß ein Halbleitermaterial verwendet ist, das direkten Bandübergang seiner Bandstruktur hat.

9. Halbleiter-Diode nach einem der Ansprüche 1 bis 8, gekennzeichnet dadurch, daß wenigstens eine der Elektroden (5, 6, 15, 16) aus einem Halbleiter-Metall-Verbundmaterial besteht.

10. Verwendung einer Halbleiter-Diode nach einem der Ansprüche 1 bis 9 als foto-voltaischer Detektor für sichtbare und/oder ultraviolette und/oder infrarote elektromagnetische Strahlung.

11. Anwendung einer Diode nach einem der Ansprüche 1 bis 9 als Klammer-Diode (clamping Diode) in Verbindung mit einem Bipolartransistor.

12. Verwendung einer Diode nach einem der Ansprüche 1 bis 9 als Frequenzwandler (Fig. 12).

13. Verwendung einer Diode nach einem der Ansprüche 1 bis 9 als Mischer (Fig. 13).

14. Verwendung einer Diode nach einem der Ansprüche 1 bis 9 als Gleichrichter für sehr kleine Wechselspannungen (0-Punkts-Detektor, zero-bias-detector).

15. Halbleiter-Diode nach einem der Ansprüche 1 bis 9 als insbesondere mit hoher Frequenz modulierbare Lumineszenzdiode.

## Revendications

1. Diode à semiconducteurs comportant une structure à 3 couches semiconductrices npn ou pnp juxtaposées et comportant des contacts ohmiques, caractérisée par le fait que pour réduire la barrière énergétique, l'épaisseur d de la couche (3, 13) (base B), qui est la couche médiane dans la structure à 3 couches, est choisie suffisamment mince pour que déjà sans application d'une tension électrique extérieure aux électrodes (5, 6, 15, 16), pour le dopage indiqué de cette couche (3, 13), l'ensemble de la zone de cette couche (3, 13) soit appauvri en porteurs de charge libres. (figure 1, figure 10).

2. Diode à semiconducteurs suivant la revendication 1, caractérisée par le fait que les densités de dopage dans toutes les couches de la structure à 3 couches sont identiques.

3. Diode à semiconducteurs suivant la revendication 1, caractérisée par le fait que les densités de dopage dans les couches de la structure 3 couches sont différentes.

4. Diode à semiconducteurs suivant la revendication 1, 2 ou 3, caractérisée par le fait que les sections transversales ou les surfaces limites superposées des couches de la structure à 3 couches ont des tailles qui sont toutes identiques.

5. Diode à semiconducteurs suivant la revendication 1, 2 ou 3, caractérisée par le fait que les surfaces respectives de jonction pn des 3 couches à structure à 3 couches ont des tailles différentes.

6. Diode à semiconducteurs suivant l'une des revendications 1 à 5, caractérisée par le fait que les couches (2, 3, 4, 12, 13, 14) de la structure à couches sont toutes constituées par le même matériau semiconducteur.

7. Diode à semiconducteurs suivant l'une des revendications 1 à 5 caractérisée par le fait que les couches (2, 3, 4, 12, 13, 14) de la structure à couches sont constituées par au moins deux matériaux semiconducteurs différents l'un de l'autre.

8. Diode à semiconducteurs suivant la revendication 7, caractérisée par le fait qu'on utilise un matériau semiconducteur qui possède une jonction de bande directe dans sa structure de bandes.

9. Diode à semiconducteurs suivant l'une quelconque des revendications 1 à 8, caractérisée par le fait qu'au moins l'une des électrodes (5, 6, 15, 16) est constituée par un matériau composite semiconducteur-métal.

10. Utilisation d'une diode à semiconducteurs suivant l'une des revendications 1 à 9 en tant que détecteur photovoltaïque pour un rayonnement électromagnétique visible et/ou ultraviolet et/ou infrarouge.

11. Utilisation d'une diode suivant l'une des revendications 1 à 9 en trant que diode de blocage (clamping diode) en liaison avec un transistor bipolaire.

12. Utilisation d'une diode suivant l'une des revendications 1 à 9 en tant que convertisseur de fréquence (figure 12).

13. Utilisation d'une diode suivant l'une des revendications 1 à 9 en tant que mélangeur (figure 13).

14. Utilisation d'une diode suivant l'une des revendications 1 à 9 en tant que redresseur pour de très faibles tensions alternatives (détecteur de point 0, zero-bias-detector).

15. Diode à semiconducteurs suivant l'une des revendications 1 à 9 servant notamment de diode à luminescence pouvant être modulée par une autre fréquence.

## Claims

1. Semiconductor diode which has an npn- or pnp-3-layer structure consisting of three adjoining semiconductor layers, and which has ohmic contacts, characterised in that to decrease the energy

**0 003 130**

barrier, the central layer (3, 13) (basis B) in the 3-layer structure has a thickness $d$ which is so small that, for the given doping of this layer (3, 13) the whole extent of this layer (3, 13) is impoverished in free charge carriers even when an external electric voltage is not applied to the electrodes (5, 6, 15, 16). (Fig. 1, Fig. 10).

2. Semiconductor diode according to Claim 1, characterised in that the doping densities are identical in all the layers of the 3-layer structure.

3. Semiconductor diode according to Claim 1, characterised in that the doping densities are different in the layers of the 3-layer structure.

4. Semiconductor diode according to Claim 1, 2, or 3, characterised in that the sizes of the cross-sections and of the boundary surfaces lying above one another of the layers of the 3-layer structure are identical.

5. Semiconductor diode according to Claim 1, 2, or 3, characterised in that the respective pn-junction surfaces of the three layers of the 3-layer structure differ in size (Fig. 10).

6. Semiconductor diode according to one of the Claims 1 to 5, characterised in that all the layers (2, 3, 4, 12, 13, 14) of the layer structure consist of the same semiconductor material.

7. Semiconductor diode according to one of the Claims 1 to 5, characterised in that the layers (2, 3, 4, 12, 13, 14) of the layer structure consist of at least two different semiconductor materials.

8. Semiconductor diode according to Claim 6 or 7, characterised in that a semiconductor material is used the band structure of which has direct band transition.

9. Semiconductor diode according to one of the Claims 1 to 8, characterised in that at least one of the electrodes (5, 6, 15, 16) consists of a semiconductor-metal compound material.

10. Use of a semiconductor diode according to one of the Claims 1 to 9 as a photo-voltaic detector for visible and/or ultra-violet and/or infrared electro-magnetic radiation.

11. Use of a diode according to one of the Claims 1 to 9 as a clamping diode in conjunction with a bipolar transistor.

12. Use of a diode according to one of the Claims 1 to 9 as a frequency converter (Fig. 12).

13. Use of a diode according to one of the Claims 1 to 9 as a mixer (Fig. 13).

14. Use of a diode according to one of the Claims 1 to 9 as a rectifier for a very small alternating voltage (zero-bias-detector).

15. Semiconductor diode according to one of the Claims 1 to 9 as a luminescence diode which can be modulated in particular by means of a high frequency.

7

Fig.1

Fig.2

Fig.3

Fig.4

Fig.5

Fig.6

Fig.7

Fig.8

Fig.9

$I_S \simeq 500 \ A/cm^2$

d = 75nm

d = 60 nm

**FIG 10**

**FIG 11**

**FIG 12** input $f_1$

$f_2$ output

**FIG 13**

input 1 $f_3$

$f_4$ input 2

$f_5$ output